(19)

Europäisches
Patentamt
European
Patent Office
Office européen
des brevets

(11) **EP 4 122 745 A1**

(12) **EUROPEAN PATENT APPLICATION**

(43) Date of publication:
**25.01.2023 Bulletin 2023/04**

(21) Application number: **22158984.9**

(22) Date of filing: **25.02.2022**

(51) International Patent Classification (IPC):
*B60L 3/00* (2019.01)     *B60L 3/04* (2006.01)
*B60L 53/14* (2019.01)     *G01R 31/00* (2006.01)
*G01R 31/08* (2020.01)     *H04W 4/38* (2018.01)
*H04W 4/44* (2018.01)

(52) Cooperative Patent Classification (CPC):
**H04W 4/38; B60L 3/00; B60L 3/04; B60L 53/14;
G01R 31/005; G01R 31/08; H04W 4/44;**
B60L 2260/44; B60L 2260/46; Y02T 10/70

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **11.03.2021 SE 2150281**

(71) Applicant: **CTEK Sweden AB
776 70 Vikmanshyttan (SE)**

(72) Inventor: **SVEDLUND, Jerry
792 37 Mora (SE)**

(74) Representative: **Brann AB
P.O. Box 3690
Sveavägen 63
103 59 Stockholm (SE)**

Remarks:
Claims 16 to 20 are deemed to be abandoned due to non-payment of the claims fees (Rule 45(3) EPC).

(54) **METHOD FOR DETECTING PERFORMANCE DETERIORATION OF COMPONENTS**

(57) The present disclosure relates to a method performed by a control unit (730) for detecting performance deterioration of components (121-126) comprised in a coupling chain (120) connecting a power grid (121) to a vehicle (110), wherein the coupling chain (120) at least comprises a supply unit (124) configured to charge the vehicle (110), the method comprising measuring amplitude of a first voltage (V1) at a first point of the coupling chain (120), measuring amplitude of a second voltage (V2) at a second point of the coupling chain (120), measuring a first current (11) flowing through the coupling chain (120), estimating an impedance using the measured amplitude of the first voltage (V1), the amplitude of the second voltage (V2) and the first current (11), detecting that performance deterioration of components comprised in the coupling chain has occurred by comparing the estimated impedance to a reference impedance, wherein the deterioration of components is detected if the estimated impedance is equal to or greater than the reference impedance, and no deterioration of components is detected if the estimated impedance is less than the reference impedance.

Fig. 1

## Description

### TECHNICAL FIELD

The present invention relates to a method for detecting performance deterioration of components. In particular, a method for detecting performance deterioration for components in a coupling chain supplying electrical power from a power grid to a vehicle.

### BACKGROUND

When charging vehicles, such as fully electric or plug-in hybrid vehicles, a supply unit is typically used to distribute electric power from a power grid to a connected vehicle. The supply unit is typically connected to the power grid via a chain of components including a grid plug and cable, and further connected to the vehicle by a charging cable.

Examples of supply units are Electric Vehicle Supply Equipment, EVSE, or In Cord - Control and Protection Device, IC-CPD, or any other suitable charger. To minimize the time spent charging the vehicle, the whole chain of components must perform according to specifications to avoid prolonged charging times and/or excessive heat generation in components of the chain.

A problem in conventional charging systems is that it is problematic to ensure performance of a charging system as a number of parties are involved in sales, installation, maintenance and use of the charging system. Further, a large number of components are part of a chain coupling the power grid to the vehicle, e.g., plugs, cables, circuitry etc.

In one example, if the supply unit is connected to a faulty wall socket, the performance of the charging system will be degraded, and the plug/socket will generate excessive heat. In a worst-case scenario, the socket or the plug inserted into the socket could catch fire.

In other words, regardless of which component that fails in a chain coupling the power grid to the vehicle, the user of the vehicle will perceive that the supply unit is faulty, even if other components are the cause. In a worst-case scenario, the failed component could catch fire.

Some conventional solutions partially address this problem by including temperature sensors in components of the coupling chain, e.g., in a grid plug. See e.g., document US2016107530-A1, which describes how a charging current of a supply unit is adjusted in response to output from a temperature sensor in a grid plug. When an increased temperature is detected, the flow of current to the vehicle may be interrupted or reduced.

Thus, there is a need for an improved method for detecting performance deterioration of components.

### OBJECTS OF THE INVENTION

An objective of embodiments of the present invention is to provide a solution which mitigates or solves the drawbacks described above.

### SUMMARY

The above objective is achieved by the subject matter described herein. Further advantageous implementation forms of the invention are described herein.

According to a first aspect of the invention the object of the invention is achieved by a method performed by a control unit for detecting performance deterioration of components comprised in a coupling chain connecting a power grid to a vehicle, wherein the coupling chain at least comprises a supply unit configured to charge the vehicle, the method comprising measuring amplitude of a first voltage at a first point of the coupling chain, measuring amplitude of a second voltage at a second point of the coupling chain, measuring a first current flowing through the coupling chain, estimating an impedance using the measured amplitude of the first voltage, the amplitude of the second voltage and the first current, detecting that performance deterioration of components comprised in the coupling chain has occurred by comparing the estimated impedance to a reference impedance, wherein the deterioration of components is detected if the estimated impedance is equal to or greater than the reference impedance, and no deterioration of components is detected if the estimated impedance is less than the reference impedance.

The advantage of this first aspect includes at least reducing complexity of a charging system by detecting performance deterioration of components in a coupling chain without the need for additional sensors, such as temperature sensors. A further advantage is that performance deterioration of components can be detected at any location along the coupling chain.

According to a second aspect of the invention the object of the invention is achieved by a control unit configured to detect performance deterioration of components comprised in a coupling chain connecting a power grid to a vehicle, the control unit comprising a transceiver communicatively coupled to a communications network and configured to exchange messages via the communications network, a processor, and a memory, said memory containing instructions executable by said processor, wherein said control unit is configured to perform the method according to the first aspect.

According to a third aspect of the invention the object of the invention is achieved by a supply unit comprising the control unit according to the second aspect.

According to a fourth aspect of the invention the object of the invention is achieved by a vehicle comprising the control unit according to the second aspect.

According to a fifth aspect of the invention the object of the invention is achieved by a cloud server comprising the control unit according to the second aspect.

According to a sixth aspect of the invention the object of the invention is achieved by a computing device comprising the control unit according to the second aspect.

According to a seventh aspect of the invention the object of the invention is achieved by a computer program product comprising instructions which, when the program is executed by a computer, cause the computer to carry out the method according to the first aspect.

According to an eighth aspect of the invention the object of the invention is achieved by a computer-readable storage medium comprising instructions which, when executed by a computer, cause the computer to carry out the steps of the method according to the first aspect.

The advantages of the second to the eighth aspects are at least the same as for the first aspect.

The scope of the invention is defined by the claims, which are incorporated into this section by reference. A more complete understanding of embodiments of the invention will be afforded to those skilled in the art, as well as a realization of additional advantages thereof, by a consideration of the following detailed description of one or more embodiments. Reference will be made to the appended sheets of drawings that will first be described briefly.

## BRIEF DESCRIPTION OF THE DRAWINGS

**Fig. 1** illustrates a charging system for a vehicle.

**Fig. 2** shows a flowchart of a method according to one or more embodiments of the present disclosure.

**Fig. 3** illustrates an embodiment where voltage amplitudes are measured in the supply unit and in the vehicle.

**Fig. 4** illustrates an embodiment where both voltage amplitudes are measured at different points within the supply unit according to one or more embodiments of the present disclosure.

**Fig. 5** illustrates an embodiment where both voltage amplitudes are measured at the same point within the supply unit according to one or more embodiments of the present disclosure.

**Fig. 6** illustrates sensors for measuring voltages and currents in the coupling chain.

**Fig. 7** shows a charging system communicating via a communications network.

**Fig. 8** shows the control unit according to one or more embodiments of the present disclosure.

A more complete understanding of embodiments of the invention will be afforded to those skilled in the art, as well as a realization of additional advantages thereof, by a consideration of the following detailed description of one or more embodiments. It should be appreciated that like reference numerals are used to identify like elements illustrated in one or more of the figures.

## DETAILED DESCRIPTION

The present disclosure relates to detecting performance deterioration of components comprised in a coupling chain. The coupling chain is typically part of a vehicle charging system. An example of a coupling chain is a grid plug, and a grid cable connecting a public or private power grid to Electric Vehicle Supply Equipment EVSE. Further parts of the coupling chain are e.g., a charging cable coupled to the EVSE allowing the charging cable to connect to an electric vehicle via a connector/charge gun.

Performance deterioration may typically be caused by various different faults, e.g., a fault introduced when manufacturing components, a fault caused by faulty installation or a fault due to component wear/failure or handling.

The present disclosure detects performance deterioration by monitoring an estimated impedance of the coupling chain and comparing it with a reference impedance. If the estimated impedance exceeds a threshold, performance deterioration of components comprised in the coupling chain is detected.

In other words, the present disclosure provides a means to ensure performance of a charging system.

Generally, all terms used herein are to be interpreted according to their ordinary meaning in the relevant technical field, unless a different meaning is clearly given and/or is implied from the context in which it is used. All references to a/an/the element, apparatus, component, means, step, etc. are to be interpreted openly as referring to at least one instance of the element, apparatus, component, means, step, etc., unless explicitly stated otherwise. The steps of any methods disclosed herein do not have to be performed in the exact order disclosed, unless a step is explicitly described as following or preceding another step and/or where it is implicit that a step must follow or precede another step. Any feature of any of the embodiments disclosed herein may be applied to any other embodiment, wherever appropriate. Likewise, any advantage of any of the embodiments may apply to any other embodiments, and vice versa. Other objectives, features and advantages of the enclosed embodiments will be apparent from the following description.

An "or" in this description and the corresponding claims is to be understood as a mathematical OR which covers "and" and "or", and is not to be understand as an XOR (exclusive OR). The indefinite article "a" in this disclosure and claims is not limited to "one" and can also be understood as "one or more", i.e., plural.

The term "battery" or "vehicle battery" used herein denotes batteries adapted to be comprised in a vehicle. The battery is typically used for powering a drive unit of the vehicle. It is understood that such batteries can be used in other applications without diverting from the present disclosure.

The term "performance deterioration of components", used herein denotes a reduction in performance compared to reference parameters or reference performance levels. An example of performance of a charging system is the size of a charging current delivered to a vehicle, which is typically defined in specifications or standards. A further example of deterioration of components are worn wall sockets of the power grid, leading to an increase of generated heat in the wall socket.

The term "components" used herein denotes electrical components or modules configured to conduct electric energy. Examples of components are plugs, sockets, cables, switches, control logic or any circuitry used to enable or control the flow of an electric current from a power grid to a vehicle.

The term "coupling chain" denotes electric or electronic components, arrangements or modules electrically coupled in a chain such that an electric current can flow through them, e.g., flow from a utility power grid to a vehicle.

The terms "utility power grid", "power grid" or simply "grid" is used interchangeably and denotes a local, regional or national network for providing utility electricity.

The term "supply unit", used herein denotes a module that comprises at least a switch and control logic and is configured to close a circuit to allow electric energy to flow from an input port to an output port, or to interrupt/disconnect a circuit to stop electric energy to flow from the input port to the output port. Examples of a supply units are an Electric Vehicle Supply Equipment, EVSE, or an In Cord - Control and Protection Device, IC-CPD. The supply unit may be configured to provide single- or three-phase AC power to the vehicle. The supply unit may further be capable of providing different levels of AC voltage including, but not limited to, Level 1 - 120-volt AC charging, Level 2 - 240V AC charging, 400 V AC charging and any other relevant voltage for AC charging.

In the present disclosure, a trained model or training of a model signifies the step of producing a model from a set of data by using machine learning. In one example this involves obtaining a training data set, having predetermined input values and/or desired output values. This may include measured amplitudes of voltages, measured currents, and measured impedances. The model may then be trained using machine learning, e.g., unsupervised, or supervised learning, by repeatedly providing the input values to candidate models and registering model output values and calculating performance measure for each candidate model based on the training output values and model output values. The candidate model producing the highest performance measure is then selected as the trained model. The trained model may e.g., be configured to predict performance and/or predict the need of maintenance of components. The model may in one example be trained by selecting from any number of candidate models forming a hypothesis space, based on a performance measure. The performance measure may indicate how well the model output corresponds to the desired output in the training set for the model. The candidate model producing the highest performance measure may then be selected as the trained model. This may also be seen as tuning parameters of the model. Examples of machine learning training methods/techniques are supervised classification methods such as Support Vector Machines, Naive Bayes, and k-Nearest Neighbour.

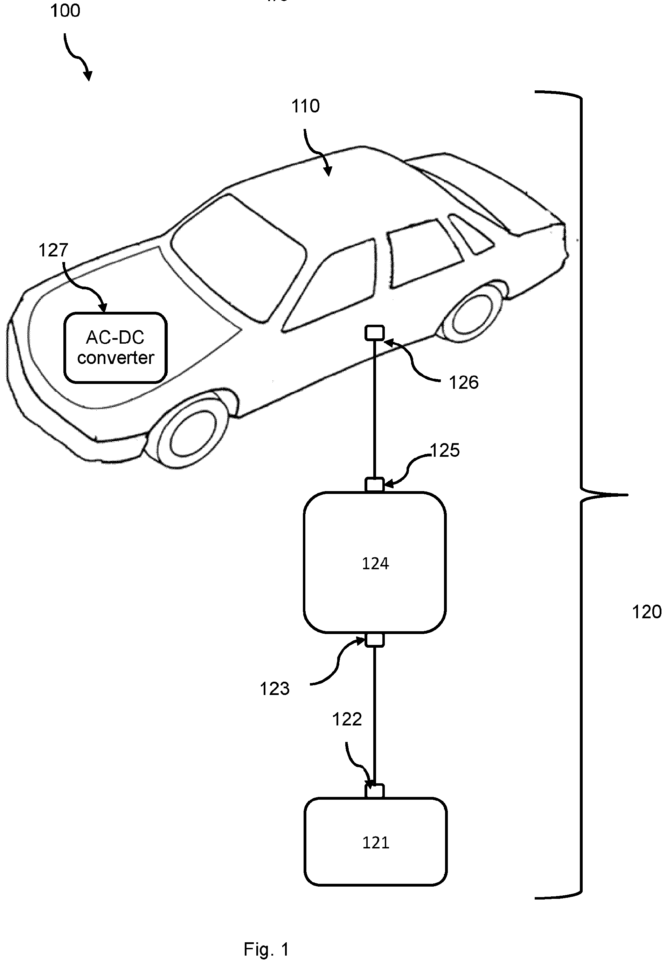

**Fig. 1** illustrates a charging system 100 for a vehicle. The vehicle is typically an electric vehicle or a hybrid vehicle. The charging system provides direct current, DC, power to batteries of a vehicle using alternating current, AC, power drawn/sourced from a power grid 121. The system is provided with components, which includes at least a supply unit 124, e.g., in the form of an Electric Vehicle Supply Equipment, EVSE, or an In Cord - Control and Protection Device, IC-CPD.

The supply unit 124 is coupled to an output port 122 of the power grid 121, typically via a cable connecting output port 122 of the power grid 121 to an input port 123 of the supply unit 124. The output port 122 and input port 123 may e.g., be a terminal block or a socket and a plug. The supply unit 124 may further comprise circuitry and/or components, such as a control unit, display, indicator lights, conductors, relays and a residual current device.

The supply unit 124 is further coupled to an input port 126 of the vehicle 110, typically via a cable connecting an output port 125 of the supply unit 124 to an input port 126 of the vehicle 110. The output port 125 and input port 126 may e.g., comprise a terminal block or a socket and a plug. In one example a connector or a charge gun connects a charging cable coupled to the supply unit 124 to the vehicle 110.

The vehicle 110 further comprises additional components, such as an AC-DC converter unit 127 and conductors electrically coupling the input port 126 to the AC-DC converter unit 127 and/or batteries of the vehicle 110.

As can be seen in Fig. 1, a selection of the components mentioned above, are electrically connected or coupled in series to form a coupling chain 120 connecting the power grid 121 to the vehicle 110. A current will flow through the coupling chain 120 to charge the vehicle 110, or more precisely charge batteries/accumulators of the vehicle.

In one example, the power grid 121 is electrically connected to a wall socket into which a grid plug of a grid cable is inserted. i.e., the wall socket and the grid plug form an output port 122 of the power grid 121. At the other end of the grid cable, a supply plug is mounted and inserted into a receiving supply socket of the supply unit 124. I.e., the supply plug and the receiving supply socket form an input port 123 of the supply unit 124. The supply unit 124 comprises at least control logic or a control unit controlling a switch, such as a relay, configured to close a circuit to allow current to flow through the coupling chain 120 or to break the circuit to stop current from flowing through the coupling chain 120. The supply unit 124 is further provided with an output socket where an output plug, electrically coupled to a charging cable, is inserted. Alternatively, the charging cable may be coupled directly to the supply unit 124, e.g., via a terminal block. At the other end of the charging cable, a charging plug is mounted and electrically connected to the charging cable. The charging plug is inserted into a charging socket of the vehicle. The charging socket of the vehicle is then typically electrically connected to an AC-DC converter unit 127, configured to convert the received AC power to DC power for charging a battery comprised in the vehicle.

It is understood that the order of socket/plug may be changed to plug/socket or replaced with a terminal block for receiving cables directly, without deviating from the present disclosure.

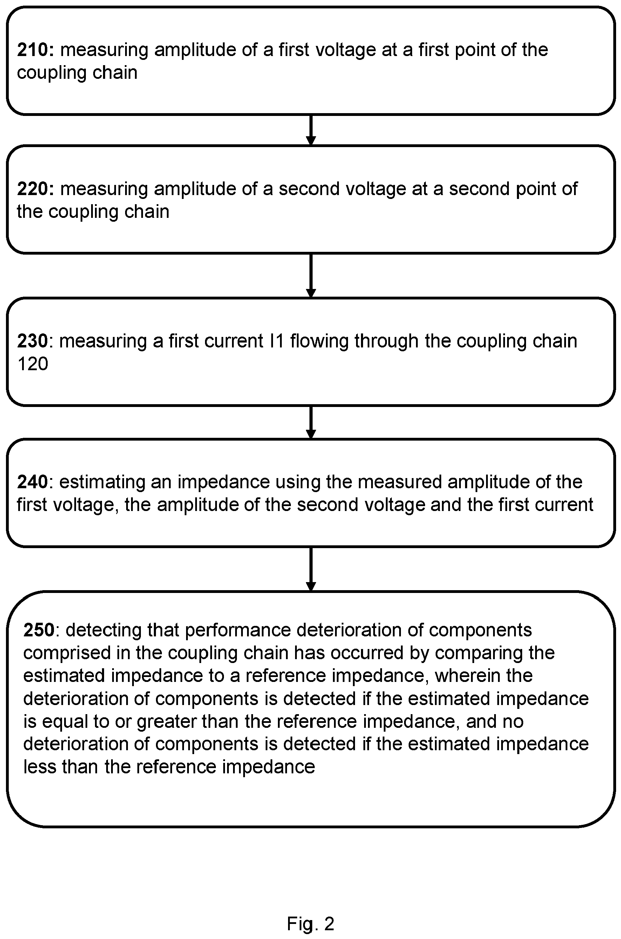

**Fig. 2** shows a flowchart of the method according to one or more embodiments of the present disclosure. The method is adapted for detecting performance deterioration of components 121-126 comprised in a coupling chain 120 connecting a power grid 121 to a vehicle 110. The coupling chain 120 comprises at least a supply unit 124 configured to charge the vehicle 110. The method comprises:

> **Step 210:** measuring amplitude of a first voltage V1 at a first point of the coupling chain 120. The power grid supplies AC power that flows through the coupling chain 120. Sensors may be placed at one or more predetermined locations along the coupling chain 120 to measure amplitude of the first voltage.

> **Step 220:** measuring amplitude of a second voltage V2 at a second point of the coupling chain 120. The power grid supplies AC power that flows through the coupling chain 120. Sensors may be placed at one or more predetermined locations along the coupling chain 120 to measure amplitude of the second voltage.

Examples of voltage sensors are capacitive type voltage sensors and resistive type voltage sensors. They typically include a voltage divider and an analog to digital converter.

**Step 230:** measuring a first current 11 flowing through the coupling chain 120. Sensors may be placed at one or more predetermined locations along the coupling chain 120 to measure the first current 11. Optionally a second current I2 may be measured at the first point, the second point or at any other suitable point in the coupling chain 120.

Examples of current sensors are closed loop current sensors and open loop current sensors. They typically include a transformer with primary and secondary coil and an analog to digital converter.

**Step 240:** estimating an impedance using the measured amplitude of the first voltage, the amplitude of the second voltage and the first current 11. The impedance may be estimated using a predetermined relation:

$$Z = \frac{(|V1 - V2|)}{I1}$$

where Z is the estimated impedance, V1 is the amplitude of the first voltage, V2 is the amplitude of the second voltage, and I1 is the measured first current or the amplitude of the measured first current. The | | surrounding the voltage difference indicates that an absolute value of the difference V1-V2 is calculated.

**Step 250:** detecting that performance deterioration of components comprised in the coupling chain has occurred by comparing the estimated impedance to a reference impedance, wherein the deterioration of components is detected if the estimated impedance is equal to or greater than the reference impedance, and no deterioration of components is detected if the estimated impedance is less than the reference impedance.

The reference impedance may be predetermined and can be retrieved from local memory or remotely connected memory. E.g., a control unit may retrieve the reference impedance from an internal memory or receive the reference impedance in a message from another node 110, 124, 121, 720 over a communications network. The reference impedance may e.g., be indicative of a sum of a typical impedance and a tolerance/margin impedance. The tolerance/margin impedance is typically set as a margin in the ranges of [1 %-20%], [20%-100%] and [100%-] of the typical impedance. 20% variation of the impedance is considered normal variation. 20%-100% variation of the impedance indicates a less serious deterioration. A variation of the estimated impedance 100% or greater than the typical impedance is indicative of a serious deterioration.

In one example, if a less serious deterioration is detected, the current flowing through the charging system may be reduced by the supply unit. In one example, if a serious deterioration is detected, the current flowing through the charging system may be completely cut-off or interrupted.

In one example, the first voltage V1 is measured at a first point, the first point being an input port/supply socket 123 of the supply unit 124. The second voltage V2 is measured at a second point, the second point being an input port/charging socket 126 of the vehicle 110. V1 is measured to be 230 Volts, and V2 is measured to be 220 Volts. I.e., a measurement value of 230 is obtained for V1 and a measurement value of 220 is obtained for V2. A current I1 is measured at a third point at a circuit board located between the first and second point, e.g., at a circuit board in the supply unit 124. The first current I1 is measured to 1.0 Ampere. The impedance Z can then be estimated to (|230-220|)/1=10 Ohms. A reference impedance can then be obtained from memory, e.g., from memory of a control unit located in the supply unit 124. In this example, the reference impedance is set to 1 Ohm. This means that the estimated impedance is greater than the reference impedance, and performance deterioration of components located between the first and second point can be detected.

In one embodiment, the steps 210-240 are repeated a plurality of times, thereby generating a set of estimated impedances that used to generate an aggregated impedance. The aggregated impedance is then used in step 250 for detecting that performance deterioration of components has occurred. In one example, the set of estimated impedances are used to generate an average impedance or geometric average impedance, which is then used in step 250 for detecting that performance deterioration of components has occurred. The advantage of this embodiment is at least that the quality of the detection is improved.

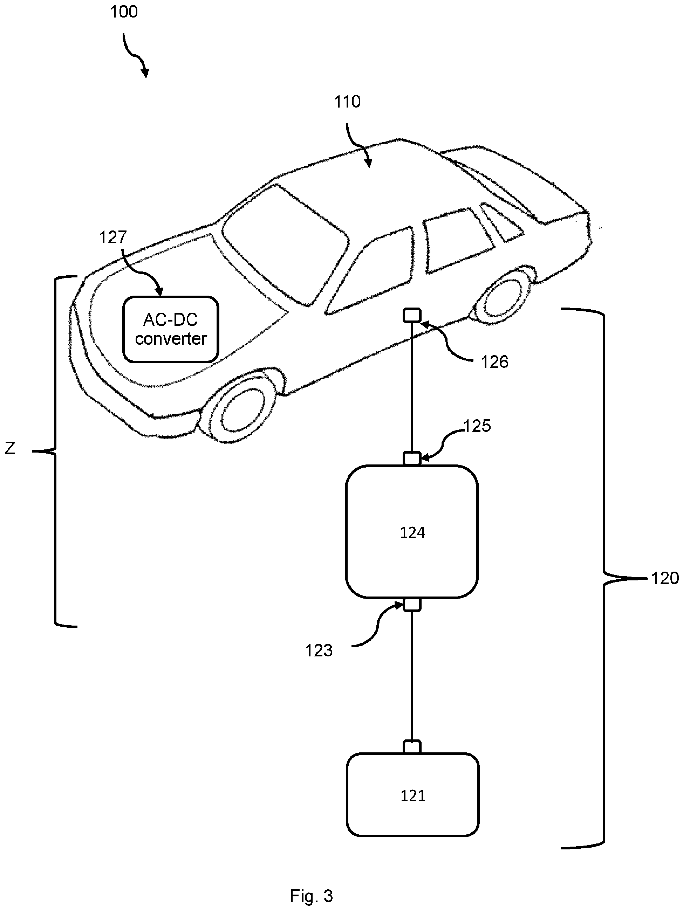

**Fig. 3** illustrates an embodiment where voltage amplitudes are measured in the supply unit 124 and in the vehicle 110. In this embodiment, the impedance Z is estimated using a first measurement point 123->125 located in the supply unit 124 and a second measurement point 126->127 located in the vehicle 110. In this embodiment, the first point/measurement point is selected at a point located between an input port 123 and an output port 125 of the supply unit 124. The second point/measurement point is selected at a point located between an input port 126 of the vehicle 110 and an alternating current, AC, to direct current, DC, converter unit 127 comprised in the vehicle 110.

In one example, the first point is selected at a receiving grid socket part of an input port 123 of the supply unit 124. The second point is selected as the receiving charging socket part of an input port 126 of the vehicle 110.

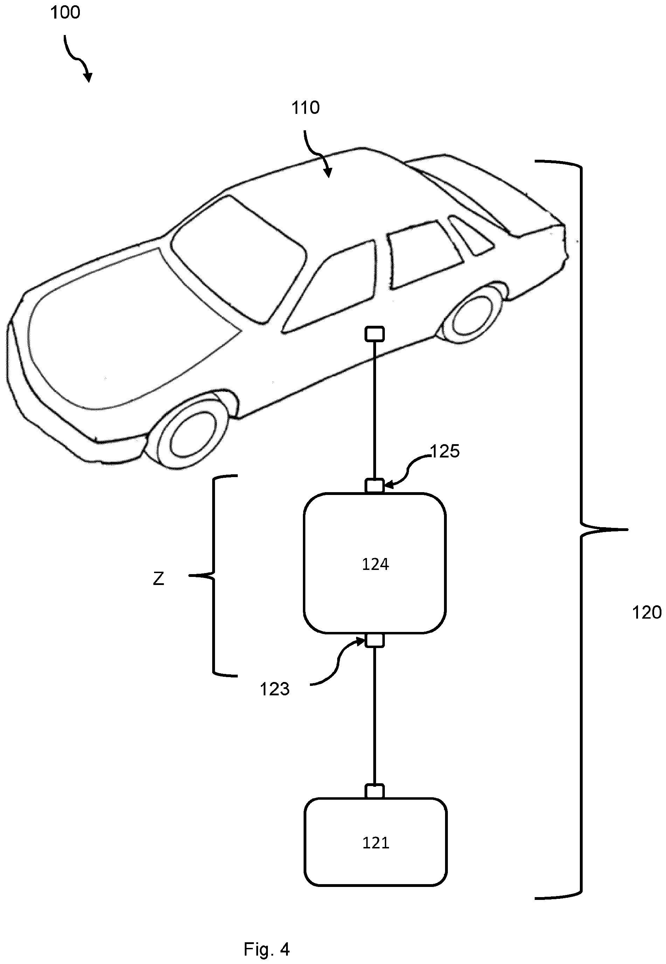

**Fig. 4** illustrates an embodiment where both amplitudes are measured at different points within the supply unit 124. In this embodiment, the impedance Z is estimated using the two different points. The first point and the second point of the coupling chain 120 are selected at two points located between the input port 123 and the output port 125 of the supply unit 124. The first point and the second point of the coupling chain 120 are selected as different points within the supply unit 124. I.e., two spatially separated points are selected within the supply unit 124, and the two measured amplitudes are used to estimate the impedance Z.

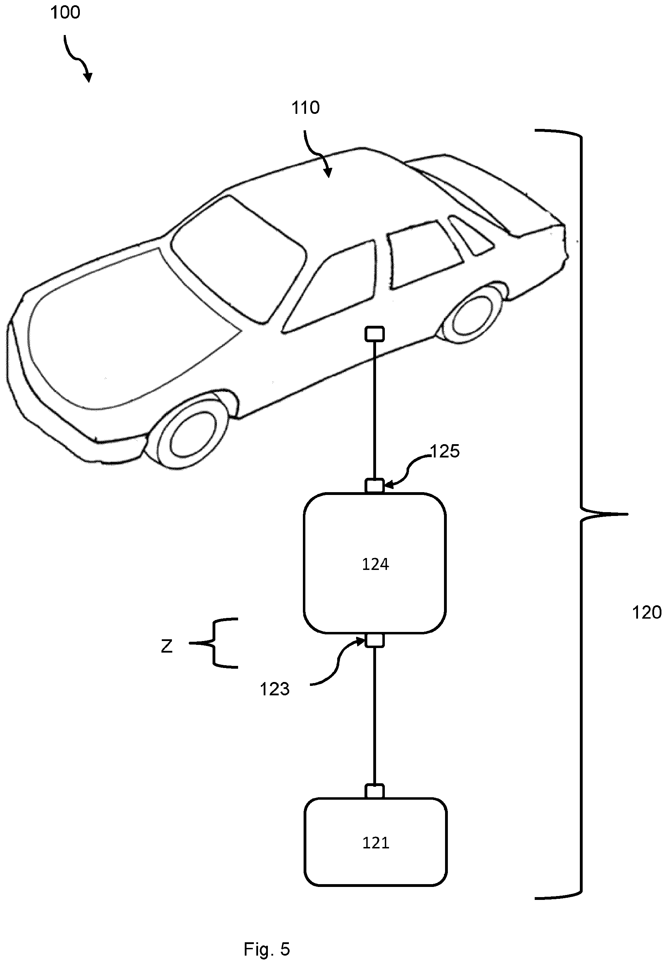

**Fig. 5** illustrates an embodiment where both amplitudes are measured at the same point within the supply unit 124. In this embodiment, the impedance Z is estimated using one single measurement point. The first point/second point of the coupling chain 120 are selected at a point at or near the input port 123 of the supply unit 124.

In this embodiment, the first point and the second point are selected at the same point. The amplitude of the first voltage V1 is measured with a part of the coupling chain 120, located after the first/second point, disconnected. I.e., the remaining part of the coupling chain 120, seen from the power grid in direction of the vehicle, is disconnected or electrically de-coupled. The disconnection or electrically de-coupling may e.g., be performed by a relay. The amplitude of the second voltage V2 is measured with the part of the coupling chain 120 connected.

In this embodiment, the method further comprises measuring a second current I2, in practical circumstances, substantially simultaneously as the second voltage V2. The estimated impedance is estimated further using the second current I2. The second current I2 may be measured at the first/second point or at any other suitable point in the coupling chain 120.

In other words, the amplitude of the first voltage V1 is measured without a load connected to the supply unit 124 and the amplitude of the second voltage V2 is measured with a load connected to the supply unit 124. A load typically connected to the supply unit 124 when charging current is provided to the battery of the vehicle by the AC/DC converter 127.

The measurements V1, V2, I1 and I2 may be performed by receiving signals from suitable sensors electrically coupled to or acting on the coupling chain 120.

In one further embodiment, using a similar approach as shown in Fig. 5, both amplitudes are measured at the same measurement point within the supply unit 124. In this embodiment, the first voltage V1 and the first current are measured at a first point in time T1, and the second voltage V2 and the second current I2 are measured at a second point in time T2.

In this embodiment, the first point and the second are selected at the same point. The amplitude of the first voltage V1 is measured with a part of the coupling chain 120, located after the first/second point, disconnected. The amplitude of the second voltage is measured with the part of the coupling chain 120 connected. I.e., V1 is measured without a load coupled and V2 is measured with a load coupled.

In this embodiment, the first current I1 is measured, in practical circumstances, substantially simultaneously as the first voltage V1 at a first point in time T1. It is understood that signals from sensors may have slightly different delays, and therefore it is not possible to perform the measurements exactly simultaneously. The first current I1 may be measured at the first/second point or at any other suitable point in the coupling chain 120.

Further, in this embodiment, a second current I2 is measured, in practical circumstances, substantially simultaneously as the second voltage V2 at a second point in time T2. The second current I2 may be measured at the first/second point or at any other suitable point in the coupling chain 120.

The impedance Z is estimated further using the second current 12.

The impedance may be estimated using a predetermined relation:

$$Z = \frac{(|V1 - V2|)}{|I1 - I2|}$$

As mentioned above, the steps 210-240 may be repeated to generate an aggregated impedance, e.g., an averaged value, to mitigate variations of the grid voltage over time.

In one embodiment, the steps of measuring 210 amplitude of the first voltage V1 and measuring 220 amplitude of the second voltage V2 are repeated until the first current I1 and the second current I2 differ more than a current threshold. Examples of current thresholds are 10 A, 20A, 25A, 32A and 80A.

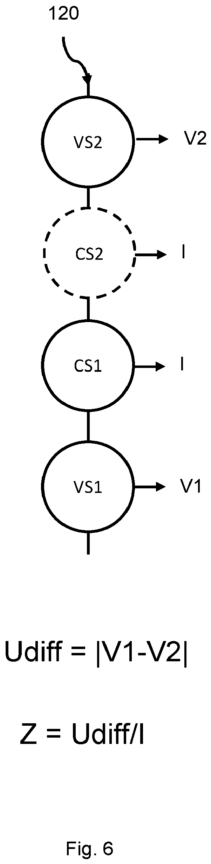

**Fig. 6** illustrates sensors for measuring voltages and currents in the coupling chain 120. As can be seen in Fig. 6, the sensors at least a first voltage sensor VS1, a second voltage sensor VS2 and a current sensor CS1 are suitably placed along the coupling chain 120 to provide measurements. Additional sensors, such as a second current sensor CS2, may be added if required.

The sensors are communicatively coupled to a control unit, either directly or via a communications network 610. The sensors VS1, VS2, CS1, CS2 typically sends a control signal indicative of measurement values to the control unit.

In one example, the first voltage sensor VS1 is located at an input port/supply socket 123 of the supply unit 124. The second voltage sensor VS2 is located at an input port/charging socket 126 of the vehicle 110. The first current sensor CS1 may be co-located with the first voltage sensor VS1.

The impedance may in one example be estimated by calculating an absolute differential voltage Udiff. The impedance can then be estimated as a quota of the differential voltage Udiff and the measurement value representing the first current I1.

If a measurement value of 230 is obtained for V1, a measurement value of 220 is obtained for V2 and a measurement value of 1.0 Ampere is obtained for 11. The impedance Z can then be estimated to (|230-220|)/1=10 Ohms.

In one embodiment of the disclosure, a message or notification is sent from the control unit to other node/s 110, 124, 121, 720, either directly or via a communications network 610. In this embodiment, a message is sent to another node upon detecting deterioration of components. In this embodiment, the method further comprises sending a message, indicative of the detection of deterioration of components, to another node 110, 124, 121, 720 via a communications network 610, if it is detected that performance deterioration of components has occurred.

In one embodiment of the disclosure, a warning light is illuminated in the control unit or in any of the other node/s 110, 124, 121, 720. In this embodiment, the method further comprises activating a warning light comprised in the control unit and/or a node 110, 124, 121, 720, if it is detected that performance deterioration of components has occurred. In one example, a light emitting diode located on the supply unit 124 is illuminated if it is detected that performance deterioration of components has occurred.

In one embodiment of the disclosure, a warning indication is generated for a displaying by a control unit 730 and/or a node 110, 124, 121, 720, if it is detected that performance deterioration of components has occurred. In one example, an alphanumeric display located on the supply unit 124 displays a warning message, e.g., "possible bad connection detected". In a further example, a display of a smartphone 720 will indicate a notification on the display, e.g., "possible bad connection detected", "possible bad connection between power grid and charger", "possible bad connection between charger and vehicle".

In one embodiment of the disclosure, the flow of current from the power grid 121 to the vehicle 110 is interrupted, if it is detected that performance deterioration of components has occurred. In one example, a relay located in the supply unit 124 breaks the circuit formed by the coupling chain 120. Thereby no charging current is provided to the vehicle 110. In this embodiment, the method further comprises controlling a disconnection of the coupling chain 120, effectively interrupting any flow of current through the coupling chain 120, if it is detected that performance deterioration of components has occurred.

In one embodiment of the disclosure, the method further comprises generating a preemptive maintenance indication. The preemptive maintenance indication is generated by feeding the measured amplitude of the first voltage V1 and/or the measured amplitude of the second voltage V2 and/or the measured first current I1 and/or the estimated impedance to a trained model. The trained model is trained using machine learning techniques, such as any of Artificial neural networks, Decision trees, Support vector machines, Regression analysis, Bayesian networks.

Historical measured amplitudes of voltages, measured currents and/or estimations of impedance may be stored from multiple charging systems, and used to train the trained model. A trained model can then be created where measurements V1, V2, 11, I2 are used as input, and a preemptive maintenance indication as output. On other words, by continuously feeding the measurements V1, V2, 11, I2 to the model, a preemptive maintenance indication may be generated and indicated by the control unit and/or another node 110, 124, 121, 720. In one example, a display of a smartphone 720 will indicate a notification on the display to relevant service staff, e.g., "service of charging system needed".

In one embodiment, the steps 210-240 are repeated a plurality of times, each time with a different selection of first and second points, e.g., (output port 122, input port 123), (input port 123, output port 125), (output port 125, input port 126), (output port 125, 127). This has the advantage of more precisely detecting a location of components that have deteriorated.

In one example a trained model, e.g., neural networks, comprised in the control unit 730, is initially trained using data collected from existing systems. E.g., data indicative the measurements V1, V2, 11, I2 and measured/calculated/estimated impedance of parts of the corresponding coupling chain 120. When a specific/particular failure occurs and service is performed, the fault, the service action and the data described above is stored. The stored data can then be used to train models to generate preemptive maintenance indications. In other words, data indicative of performance deterioration of components is used to train a model such that a preemptive maintenance indication is generated before the fault in the charging system occurs.

The preemptive maintenance indication indicates that a service operation is required. In one embodiment, the preemptive maintenance indication further indicated a confidence rating of the required service operation.

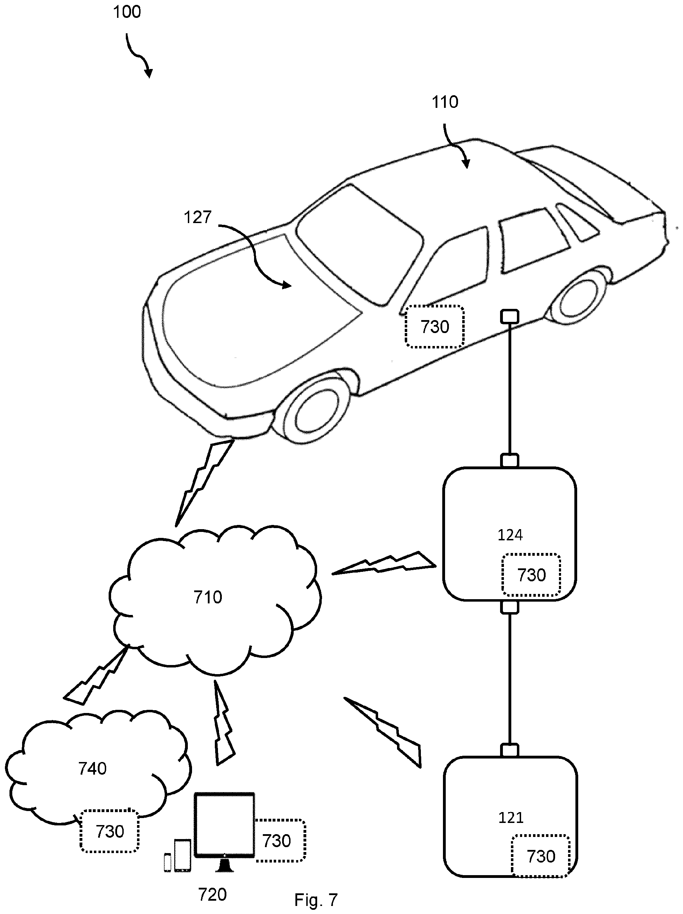

Fig. 7 shows a charging system 100 communicating via a communications network 710. The coupling chain 120, shown in Fig. 7 as formed by the power grid 121, the supply unit 124 and the vehicle 110. The power grid 121, the supply unit 124 and the vehicle 110 are electrically and serially coupled with conductors such as cables. An external computing device 720, may optionally be part of the charging system 100, e.g., a smartphone executing relevant applications. The charging system 100 may further comprise tablets/smartphone/s 720 and cloud server/s 740. All nodes 110, 121, 124, 720 are 740 communicatively coupled either directly or via the communications network 710, and configured to exchange messages indicative of data, e.g., measured voltages V1, V2 or measured currents I1, 12.

A selection of any of the nodes 110, 121, 124, 720 comprises a control unit 730, configured to perform all or a selection of the method steps described herein.

It is understood that any of the method steps 210-250 may be distributed amongst several control units 730, and intermediate results may be sent in messages between control units in the various nodes 110, 121, 124, 720.

In one example, the vehicle is provided with a first control unit configured to measuring the amplitude of the second voltage V2 at the second point of the coupling chain 120, e.g., at the charging socket of the vehicle. The first control unit then sends a message to a second control unit located at/comprising the supply unit 124 via the communications network 710 and/or via the conductor/cable connecting the vehicle 110 to the supply unit 124. The message is indicative of the measured amplitude of the second voltage V2.

The second control unit receives the message and measures amplitude of the first voltage V1 at a first point of the coupling chain 120, e.g., at the supply socket 123 of the supply unit 124. The second control unit further measuring the first current I1 flowing through the coupling chain 120, e.g., at the first point. The second control unit further estimates the impedance Z using the measured amplitude of the first voltage V1, the amplitude of the second voltage V2 and the first current I1. The second control unit further compares the estimated impedance to a reference impedance. A deterioration of components is then detected if the estimated impedance is equal to or greater than the reference impedance.

In one further example, the supply unit 124 is provided with a first control unit configured to measuring the amplitude of the first voltage V1 at the first point, the second voltage V2 and the first current I1 at the second point of the coupling chain 120. The first control unit then sends a message to a second control unit located at/comprising a cloud server 749 via the communications network 710. The message is indicative of the measured amplitude of the first and second voltage and (the amplitude of) the first current 11. The second control unit receives the message and estimates the impedance Z using the received amplitude of the first voltage V1, the received amplitude of the second voltage V2 and the received first current 11. The second control unit further compares the estimated impedance to a reference impedance. A deterioration of components is then detected if the estimated impedance is equal to or greater than the reference impedance.

Optionally, a message is sent to a smart phone 720 indicative of the determination. The smart phone then indicates a warning message to a user of the phone, e.g., by displaying a message stating, "bad component detected".

Optionally, a message is sent to the supply unit indicative of the determination. The supply unit then controls a switch to stop the flow of current to the vehicle.

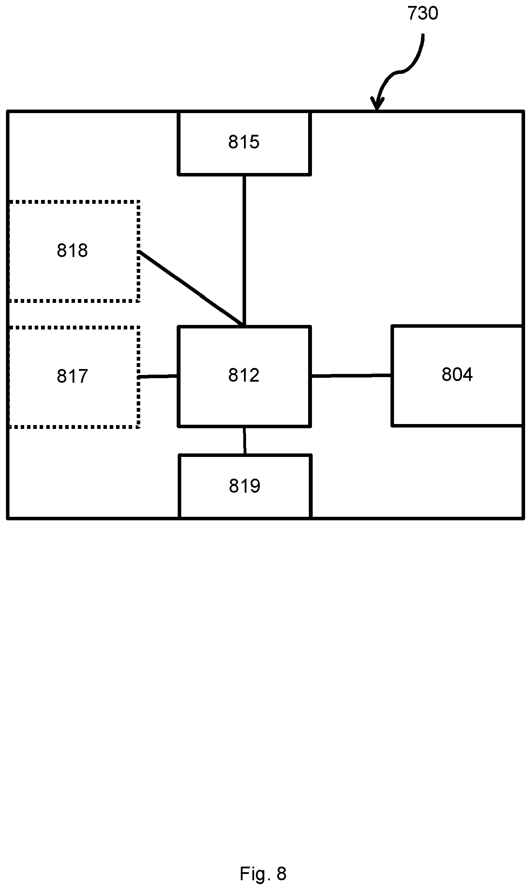

Fig. 8 shows the control unit 730 according to one or more embodiments of the present disclosure. The control unit 730 may be in the form of e.g., an Electronic Control unit, a server, an on-board computer, a stationary computing device, a laptop computer, a tablet computer, a handheld computer, a wrist-worn computer, a smart watch, a smartphone or a smart TV. The control unit 730 may comprise a processor/processing circuitry 812 communicatively coupled to a communications interface 804, e.g., a transceiver configured for wired or wireless communication. The control unit 730 may further comprise at least one optional antenna (not shown in figure). The antenna may be coupled to the transceiver and is configured to transmit and/or emit and/or receive wired or wireless signals in a communication network, such as WiFi, Bluetooth, 3G, (PLC) 4G, 5G etc. Powerline communication ISO 15118-3 DIN 70121 or pulse width modulation protocols (e.g., pilot signal from supply unit to vehicle).

In one example, the processing circuitry 812 may be any of a selection of processing circuitry and/or a central processing unit and/or processor modules and/or multiple processors configured to cooperate with each-other.

Further, the control unit 730 may further comprise a memory 815. The memory 815 may e.g., comprise a selection of a hard RAM, disk drive, a floppy disk drive, a flash drive or other removable or fixed media drive or any other suitable memory known in the art. The memory 815 may contain instructions executable by the processing circuitry to perform any of the steps or methods described herein.

The processing circuitry 812 may optionally be communicatively coupled to a selection of any of the communications interface 804, the memory 815, one or more sensors, such as battery voltage sensors measuring battery voltage over poles of the battery. The control unit 730 may be configured to send/receive control signals directly to any of the above-mentioned units or to external nodes or to send/receive control signals via the wired and/or wireless communications network.

The communications interface 804, such as a wired/wireless communications network adapter and/or a wired/wireless transceiver, may be configured to send and/or receive data values or parameters as a signal to or from the processing circuitry 812 to or from other external nodes. E.g., measured battery voltage values. In an embodiment, the communications interface 804 communicates directly to external nodes or via the wireless communications network.

In one or more embodiments the control unit 730 may further comprise an input device 817, configured to receive input or indications from a user and send a user input signal indicative of the user input or indications to the processing circuitry 812.

In one or more embodiments the control unit 730 may further comprise a display 818 configured to receive a display signal indicative of rendered objects, such as text or graphical user input objects, from the processing circuitry 812 and to display the received signal as objects, such as text or graphical user input objects.

In one embodiment the display 818 is integrated with the user input device 817 and is configured to receive a display signal indicative of rendered objects, such as text or graphical user input objects, from the processing circuitry 812 and to display the received signal as objects, such as text or graphical user input objects, and/or configured to receive input or indications from a user and send a user-input signal indicative of the user input or indications to the processing circuitry 812.

In a further embodiment, the control unit 730 may further comprise and/or be coupled to one or more additional sensors (not shown in the figure) configured to receive and/or obtain and/or measure physical properties pertaining to the control unit and/or coupling chain 120, and send one or more sensor signals indicative of the physical properties of the control unit and/or coupling chain 120 to the processing circuitry 812. E.g., an external voltage sensor measuring power grid voltage and/or ambient temperature.

In one or more embodiments, the processing circuitry 812 is further communicatively coupled to the communications interface 804 and/or the input device 817 and/or the display 818 and/or the controllable power source 819 and/or the sensors and/or the additional sensors and/or any of the units described herein.

In one embodiment, a control unit 730 is provided and is configured to detecting performance deterioration of components 121-126 comprised in a coupling chain 120, the control unit 730 comprising a processor 812, and a memory 815, said memory containing instructions executable by said processor, whereby said control unit 730 is operative and/ or configured to perform any of the method steps described herein.

In embodiments, the communications network communicate using wired or wireless communication techniques that may include at least one of a Local Area Network (LAN), Metropolitan Area Network (MAN), Global System for Mobile Network (GSM), Enhanced Data GSM Environment (EDGE), Universal Mobile Telecommunications System, Long term evolution, High Speed Downlink Packet Access (HSDPA), Wideband Code Division Multiple Access (W-CDMA), Code Division Multiple Access (CDMA), Time Division Multiple Access (TDMA), Bluetooth®, Zigbee®, Wi-Fi, Voice over Internet Protocol (VoIP), LTE Advanced, IEEE802.16m, Wireless-MAN-Advanced, Evolved High-Speed Packet Access (HSPA+), 3GPP Long Term Evolution (LTE), Mobile WiMAX (IEEE 802.16e), Ultra Mobile Broadband (UMB) (formerly Evolution-Data Optimized (EV-DO) Rev. C), Fast Low-latency Access with Seamless Handoff Orthogonal Frequency Division Multiplexing (Flash-OFDM), High Capacity Spatial Division Multiple Access (iBurst®) and Mobile Broadband Wireless Access (MBWA) (IEEE 802.20) systems, High Performance Radio Metropolitan Area Network (HIPERMAN), Beam-Division Multiple Access (BDMA), World Interoperability for Microwave Access (Wi-MAX) and Power line communication (PLC) ISO 15118-37/DIN 70121 ultrasonic communication, etc., but is not limited thereto.

Moreover, it is realized by the skilled person that control unit 730 may comprise the necessary communication capabilities in the form of e.g., functions, means, units, elements, etc., for performing the present solution. Examples of other such means, units, elements and functions are: processors, memory, buffers, control logic, encoders, decoders, rate matchers, de-rate matchers, mapping units, multipliers, decision units, selecting units, switches, modulators, demodulators, inputs, outputs, antennas, amplifiers, receiver units, transmitter units, DSPs, MSDs, TCM encoder, TCM decoder, power supply units, power feeders, communication interfaces, communication protocols, etc. which are suitably arranged together for performing the present solution.

Especially, the processing circuitry and/or processing means of the present disclosure may comprise one or more instances of processing circuitry, processor modules and multiple processors configured to cooperate with each-other, Central Processing Unit (CPU), a processing unit, a processing circuit, a processor, an Application Specific Integrated Circuit (ASIC), a microprocessor, a Field-Programmable Gate Array (FPGA) or other processing logic that may interpret and execute instructions. The expression "processing circuitry" and/or "processing means" may thus represent a processing circuitry comprising a plurality of processing circuits, such as, e.g., any, some or all of the ones mentioned above. The processing means may further perform data processing functions for inputting, outputting, and processing of data comprising data buffering and device control functions, such as user interface control, or the like.

Finally, it should be understood that the invention is not limited to the embodiments described above, but also relates to and incorporates all embodiments within the scope of the appended independent claims.

**Claims**

1. A method performed by a control unit (730) for detecting performance deterioration of components (121-126) comprised in a coupling chain (120) connecting a power grid (121) to a vehicle (110), wherein the coupling chain (120) at least comprises a supply unit (124) configured to charge the vehicle (110), the method comprising:

   measuring amplitude of a first voltage (V1) at a first point of the coupling chain (120),
   measuring amplitude of a second voltage (V2) at a second point of the coupling chain (120),
   measuring a first current (11) flowing through the coupling chain (120),
   estimating an impedance using the measured amplitude of the first voltage (V1), the amplitude of the second voltage (V2) and the first current (11),
   detecting that performance deterioration of components comprised in the coupling chain has occurred by:
   comparing the estimated impedance to a reference impedance, wherein the deterioration of components is detected if the estimated impedance is equal to or greater than the reference impedance, and no deterioration of components is detected if the estimated impedance is less than the reference impedance.

2. The method according to claim 1, wherein the first point is selected at a point located

   between an input port (123) and an output port (125) of the supply unit (124), and
   wherein the second point is selected at a point located between an input port (126) of the vehicle (110) and an alternating current, AC, to direct current, DC, converter unit (127) comprised in the vehicle (110).

3. The method according to claim 1, wherein the first point and the second point of the coupling chain (120) are selected at points located between an input port (123) and an output port (125) of the supply unit (124), wherein the first point and the second point of the coupling chain (120) are selected as different points.

4. The method according to claim 1, wherein the first point and the second are selected at the same point,

   wherein the amplitude of the first voltage (V1) is measured with a part of the coupling chain (120), located after the first/second point, disconnected, and
   the amplitude of the second voltage (V2) is measured with the part of the coupling chain (120) connected,
   wherein the method further comprises measuring a second current (12), in practical circumstances, substantially simultaneously as the second voltage, wherein the impedance of the coupling chain (120) is estimated further using the second current (12).

5. The method according to claim 1, wherein the first point and the second are selected at the same point,

   wherein the amplitude of the first voltage (V1) is measured with a part of the coupling chain (120), located after the first/second point, disconnected, and
   the amplitude of the second voltage is measured with the part of the coupling chain (120) connected,
   wherein the method further comprises:

      measuring the first current (11), in practical circumstances, substantially simultaneously as the first voltage (V1) at a first point in time (T1),
      measuring a second current (12), in practical circumstances, substantially simultaneously as the second voltage (V2) at a second point in time (T2), wherein the impedance of the coupling chain (120) is estimated further using the second current (12).

6. The method according to claim 5, wherein the steps of measuring amplitude of the first voltage (V1) and measuring amplitude of the second voltage (V2) are repeated until the first current (11) and the second current (12) differ more than a current threshold.

7. The method according to any of the preceding claims, further comprising sending a message, indicative of the detection of deterioration of components, to another node (110, 124, 121, 620) via a communications network (710), if it is detected that performance deterioration of components has occurred.

8. The method according to any of the preceding claims, further comprising activating a warning light comprised in a control unit (730) and/or a node (110, 124, 121, 720), if it is detected that performance deterioration of components has occurred.

9. The method according to any of the preceding claims, further comprising generating a warning indication for display by a control unit (730) and/or a node (110, 124, 121, 720), if it is detected that performance deterioration of components has occurred.

10. The method according to any of the preceding claims, further comprising controlling a disconnection of the coupling chain (120), effectively interrupting any flow of current through the coupling chain (120), if it is detected that performance deterioration of components has occurred.

11. The method according to any of the preceding claims, further comprising generating a preemptive maintenance indication, wherein the preemptive maintenance indication is generated by feeding the measured amplitude of the first voltage (V1), the measured amplitude of the second voltage (V2) and the measured first current (11) to a trained model, where the trained model is trained using machine learning techniques.

12. A control unit (730) configured to detect performance deterioration of components (121-126) comprised in a coupling chain (120) connecting a power grid (121) to a vehicle (110), the control unit (730) comprising:

    a transceiver (804) communicatively coupled to a communications network (710) and configured to exchange messages via the communications network (710),
    a processor (812), and
    a memory (815), said memory containing instructions executable by said processor, wherein said control unit (730) is configured to perform the method according to any of claims 1-11.

13. A supply unit comprising the control unit (730) according to claim 12.

14. The supply unit according to claim 13 wherein the supply unit comprises an Electric Vehicle Supply Equipment, EVSE, or an In Cord - Control and Protection Device, IC-CPD.

15. A vehicle (110) comprising the control unit (730) according to claim 12.

16. A cloud server comprising the control unit (730) according to claim 12.

17. A computing device (720) comprising the control unit (730) according to claim 12.

18. The computing device according to claim 16, wherein the computing device comprises any one of a charger, a server/cloud server, an on-board computer, a stationary computing device, a laptop computer, a tablet computer, a handheld computer, a wrist-worn computer, a smart watch, a smartphone or a smart TV.

19. A computer program product comprising instructions which, when the program is executed by a computer, cause the computer to carry out the method according to any of claims 1-11.

20. A computer-readable storage medium comprising instructions which, when executed by a computer, cause the computer to carry out the steps of the method according to any of claims 1-11.

100

110

127

AC-DC
converter

126

125

124

123

122

121

120

Fig. 1

**210:** measuring amplitude of a first voltage at a first point of the coupling chain

**220:** measuring amplitude of a second voltage at a second point of the coupling chain

**230:** measuring a first current I1 flowing through the coupling chain 120

**240:** estimating an impedance using the measured amplitude of the first voltage, the amplitude of the second voltage and the first current

**250:** detecting that performance deterioration of components comprised in the coupling chain has occurred by comparing the estimated impedance to a reference impedance, wherein the deterioration of components is detected if the estimated impedance is equal to or greater than the reference impedance, and no deterioration of components is detected if the estimated impedance less than the reference impedance

Fig. 2

Fig. 3

Fig. 4

Fig. 5

120

$$Udiff = |V1-V2|$$

$$Z = Udiff/I$$

Fig. 6

Fig. 7

730

Fig. 8

Europäisches
Patentamt
European
Patent Office
Office européen
des brevets

# EUROPEAN SEARCH REPORT

Application Number

EP 22 15 8984

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/115874 A1 (MAGNUSSON ANDERS [SE] ET AL) 30 April 2015 (2015-04-30) <br> * abstract * <br> * figures 1-4 * <br> * paragraphs [0004] – [0012], [0036] – [0041] * <br> ----- | 1,4-15 | INV. <br> B60L3/00 <br> B60L3/04 <br> B60L53/14 <br> G01R31/00 <br> G01R31/08 <br> H04W4/38 |
| X | US 2017/124783 A1 (ALM FILIP [SE] ET AL) 4 May 2017 (2017-05-04) <br> * abstract * <br> * figures 1-3 * <br> * paragraphs [0018] – [0020], [0050] – [0068] * <br> ----- | 1-3,7-15 | H04W4/44 |
| X | US 2015/002104 A1 (MOELL WINFRIED [DE]) 1 January 2015 (2015-01-01) <br> * the whole document * <br> ----- | 1,7-15 | |
| A | DE 10 2018 125597 B3 (ISABELLENHUETTE HEUSLER GMBH & CO KG [DE]) 6 February 2020 (2020-02-06) <br> * the whole document * <br> ----- | 1-15 | |
| | | | TECHNICAL FIELDS SEARCHED (IPC) |
| A | CN 111 382 789 A (YUNNAN POWER GRID CO LTD ELECTRIC POWER RES INST) 7 July 2020 (2020-07-07) <br> * the whole document * <br> ----- | 11 | B60L |

The present search report has been drawn up for all claims

| Place of search | Date of completion of the search | Examiner |
|---|---|---|
| The Hague | 15 December 2022 | Schmitt, Gilles |

EPO FORM 1503 03.82 (P04C01)

## ANNEX TO THE EUROPEAN SEARCH REPORT
## ON EUROPEAN PATENT APPLICATION NO.

EP 22 15 8984

This annex lists the patent family members relating to the patent documents cited in the above-mentioned European search report.
The members are as contained in the European Patent Office EDP file on
The European Patent Office is in no way liable for these particulars which are merely given for the purpose of information.

15-12-2022

| Patent document cited in search report | | Publication date | Patent family member(s) | | Publication date |
|---|---|---|---|---|---|
| US 2015115874 | A1 | 30-04-2015 | CN 104578234 A | | 29-04-2015 |
| | | | EP 2865558 A1 | | 29-04-2015 |
| | | | US 2015115874 A1 | | 30-04-2015 |
| US 2017124783 | A1 | 04-05-2017 | EP 3140148 A1 | | 15-03-2017 |
| | | | US 2017124783 A1 | | 04-05-2017 |
| | | | WO 2015169326 A1 | | 12-11-2015 |
| US 2015002104 | A1 | 01-01-2015 | CN 104283209 A | | 14-01-2015 |
| | | | DE 102013212821 A1 | | 08-01-2015 |
| | | | EP 2822127 A2 | | 07-01-2015 |
| | | | US 2015002104 A1 | | 01-01-2015 |
| DE 102018125597 | B3 | 06-02-2020 | DE 102018125597 B3 | | 06-02-2020 |
| | | | EP 3794359 A1 | | 24-03-2021 |
| | | | US 2021354585 A1 | | 18-11-2021 |
| | | | WO 2020078950 A1 | | 23-04-2020 |
| CN 111382789 | A | 07-07-2020 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016107530 A1